# EUROPEAN PATENT SPECIFICATION

(11) **EP 1 146 645 B1**
(45) Date of publication and mention of the grant of the patent: **08.09.2004**
(21) Application number: 99927651.2
(22) Date of filing: 02.07.1999
(51) Int. Cl.: H03K 17/72

(54) **A CONTACTLESS INTELLECTUAL SWITCH**
INTELLIGENTER KONTAKTLOSER SCHALTER
COMMUTATEUR D'INTELLIGENCE ARTIFICIELLE SANS CONTACTS

(30) Priority: 02.07.1998 CN 98102694
(43) Date of publication of application: 17.10.2001
(73) Proprietor: Yang, Baoyun, Beijing 100041 (CN)
(72) Inventor: Yang, Baoyun, Beijing 100041 (CN)
(74) Representative: Bjerre, Nils B.J.
(86) International application number: PCT/CN1999/000085
(87) International publication number: WO 2000/002314

(56) References cited:
- EP-A- 0 016 646
- BR-A- 9 205 391
- CN-A- 86 102 566
- CN-U- 2 115 614
- CN-Y- 2 141 622
- CN-Y- 2 185 488
- CN-Y- 2 195 160
- FR-A- 2 591 397
- RU-C- 2 001 486
- SU-A- 1 381 644
- SU-A- 1 410 179
- US-A- 4 039 928
- US-A- 4 504 778
- US-A- 4 626 978
- US-A- 4 982 143
- US-A- 5 237 244
- US-A- 5 612 596
- PATENT ABSTRACTS OF JAPAN vol. 1998, no. 02, 30 January 1998 (1998-01-30) & JP 09 257870 A (NGK INSULATORS LTD), 3 October 1997 (1997-10-03)

## Description

The present invention relates to a switchgear, and more particularly to a contactless intelligent switchgear as known from US-A 4 504 778.

### Background of the Invention

Electric switches are extensively used in everyday life and production activity. The conventional switches are mainly mechanical switches such as a manual knife switch, an electromagnetic switch and an automatic air switch etc.. The opening/closing operation of the contacts of all the switches is achieved by means of a mechanical actuating means to conduct or interrupt a current. It is well known that an arcing problem during opening of the switch contacts is the main cause that results in shorter service life of the switches and their faults. During service of the switches, the faults such as switch explosion due to an arc are commonplace, and the resultant loss of life and property is too heavy to be estimated. It is due to the effects of arc that the contacts of the switch are easy to be melting and cauterant. If the contacts are burned to have burrs, a fault may occur due to poor contact of the contacts, and if the contacts are sintered to be joined together, the contacts of the switch may not open during a short-circuit, an overcurrent or an electric shock fault so that the faulty range may become larger. Although a lot of arc suppression measures are taken, the above mentioned problems have not been completely solved. Therefore, the service life of the mechanical switches is not long enough, and their reliability is not high enough.

In order to make electric power serve the society in a safety and reliable manner, and to reduce occurrence rate of faults, the switches have to be provided with subsidiary devices such leakage protectors, overcurrent protectors, overheat protectors and fuses etc.. In order to achieve an uninterrupted power supply in production and life, it is necessary to arrange two-way power supplies. In order to achieve switch interconnection, a plurality of relays and complicated secondary wires have to be used. With the developments of automation technology, an increasing attention has been paid to the monitoring of electric switches and to the measuring of parameters, and therefore, current transformers and voltage transformers have to be provided to sample signals. In this case, not only reliability is reduced, but also installation is more difficult.

### Summary of the Invention

An object of the invention is to provide a contactless intelligent switchgear, which does not need the conventional subsidiary devices such as mechanical actuating means, mechanical contact means, and mechanical protection means as well as relays etc., and therefore, can overcome completely the arcing problem during opening/closing operation of the contacts of the switchgear .

An another object of the invention is to provide a contactless intelligent switchgear, which can fulfill various protection functions and electric energy measuring functions as well as an interlock function between a plurality of switchgears for the system controlled by the switchgear by means of microelectronics technology, and thus an uninterrupted power supply can be achieved.

According to an aspect of the invention, there is provided a contactless intelligent switchgear, comprising: a thyristor assembly, having an input terminal connected to the power supply line and having an output terminal, serving as an output terminal of the contactless intelligent switchgear, connected to a load line; a signal sampler, having an input terminal connected to a power supply line, for sampling an electric signal from the power supply line; a control device, receiving at its input terminal the sampling signal from the signal sampler, and outputting a control signal based on predetermined control conditions to control the on/off operation of said thyristor assembly, wherein said switchgear also comprises a power source device connected with said signal sampler, said thyristor assembly and said control device respectively to feed an electric power to said signal sampler, said thyristor assembly and said control device; wherein said thyristor assembly further comprises a cooling system; wherein said signal sampler also samples the temperature signal of said thyristor assembly and the leakage current of the load line; wherein said control device receives at its input terminal also the sampling signals for the leakage current and the temperature from the signal sampler, and outputs control signals based on predetermined control conditions to control also the operation of said cooling system and to fulfill a leakage protection; wherein the control device further comprises: a first isolating and amplifying device for isolating and amplifying the sampling signals from said signal sampler; an A/D converter for A/D converting the sampling signals from said first isolating and amplifying device, and outputting sampling data; a monolithic processor for receiving the sampling data from said A/D converter, making mathematical operations and logical judgements by a preset program, and outputting digital control signal based on operation demands; a D/A converter for converting the digital control signals from said monolithic processor into analog control signals; and a second isolating and amplifying device for isolating and amplifying the analog control signals from said D/A converter to control said thyristor assembly.

The control device may be connected with a computer to fulfill a real-time detection and a remote control. The signal sampler may comprise a current sampler directly connected in series between said thyristor assembly and the power supply line for sampling currents. The control device may be connected with the control devices of other contactless intelligent switchgears to exchange interlock signals, and to make judgements so as to fulfill an uninterrupted power supply.

The above features and advantages of the invention will be more apparent by way of the following detailed descriptions of the embodiments of the invention with reference to the drawings.

### Brief Description ofthe Drawings

Fig. 1 shows schematically the contactless intelligent switchgear according to the invention;
Fig. 2 shows schematically the control device of the contactless intelligent switchgear according to the invention;
Fig.3 shows the circuit diagram of the control device of the contactless intelligent switchgear according to the invention.

### Detailed Description of the Preferred Embodiments

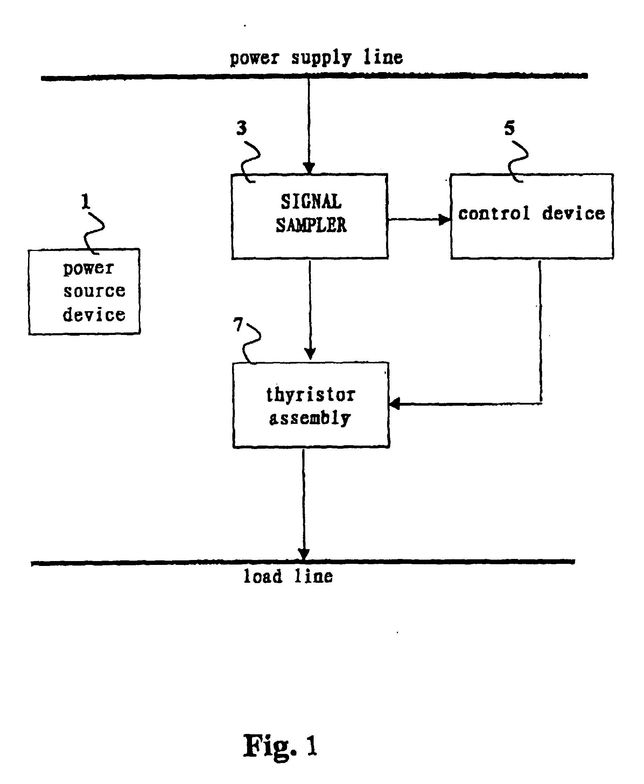

As shown in Fig.1, the contactless intelligent switchgear according to the invention comprises a power source device 1, a signal sampler 3, a control device 5 and a thyristor assembly 7 etc.. The thyristor assembly 7 has an input terminal connected to a power supply line via the signal sampler 3, and an output terminal connected to a load line. The thyristor assembly 7 has a gate connected to the control device 5, and switches on/off in response to a control signal from the control device 5 so that the on/off operation of the contactless intelligent switchgear according to the invention can be implemented by the on/off operation of the thyristor assembly 7. The signal sampler 3 samples electric signals in the power supply line, and sends them to the control device 5. The control device 5 make a judgment based on the received sampling signal, and duly sends control signals to the thyristor assembly so that various protection functions, an electric energy measuring function etc. can be achieved. The power source device supplies power to the signal sampler 3, the thyristor assembly 7 and the control device 5 of the contactless intelligent switchgear according to the invention.

The signal sampler 3 of the contactless intelligent switchgear according to the invention comprises current samplers, voltage samplers, temperature samplers, leakage current samplers etc., wherein the current samplers are a current divider made of manganin material, which are connected in series between the power supply line and the thyristor assembly, for sampling the currents in the load line and outputting analog signals. The voltage samplers, which may be a small power transformer, are used to sample the voltage of the power supply line and to output analog signals. The temperature measuring probes of the temperature samplers are arranged at temperature measuring points of the thyristor assembly 7. The measured temperature values are converted into voltage signals and then are output. The linkage current samplers are connected with the output terminals of the contactless intelligent switchgear, sample the leakage current in the load line, and convert it into voltage signals to be output. The output signals of the signal sampler 3 are sent to the control device.

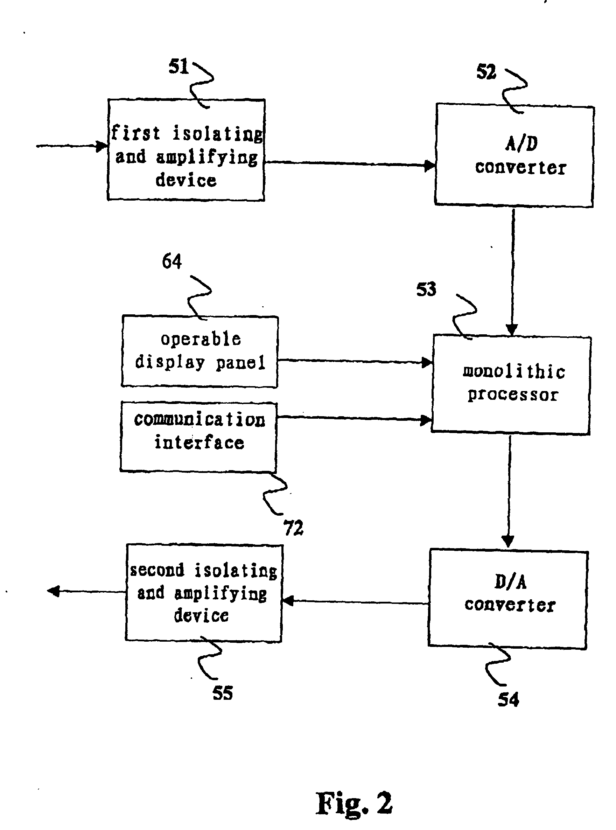

As shown in figure 2, the control device 5 of the contactless intelligent switchgear according to the invention mainly comprises a first isolating and amplifying device 51, an A/D converter 52, a monolithic processor 53, a D/A converter 54 and a second isolating and amplifying device 55. Further, the monolithic processor 53 is also connected with an operable display panel 64 and a communication interface 72 etc.. The first isolating and amplifying device 51 receives, isolates and amplifies sampling signals from the signal sampler 3, and then sends the isolated and amplified sampling signals to the A/D converter 52. The A/D converter 52 converts the isolated and amplified sampling signals into digital signals, and sends the digital signals to the monolithic processor 53. The monolithic processor 53 analyzes the digital signals and makes an judgment, and makes mathematical operations and logical judgments by a preset program in response to operating signals from the operable display panel 64, and issues digital control signals based on operating demands. The digital control signals are converted into analog control signals via the D/A converter 54. The analog control signals are isolated and amplified via the second isolating and amplifying device 55 to control the thyristor assembly 7. The communication interface 72 may be connected to a computer so as to fulfill a remote control,

The thyristor assembly 7 of the contactless intelligent switchgear according to the invention comprises an unidirectional thyristors, radiators and relevant circuits. Each phase current path consists of two unidirectional thyristors connected in inverse parallel to allow an AC current to flow. A RC circuit is connected in parallel to suppress a surge voltage in the circuit. The body of the thyristor assembly 7 is provided with radiators. The input terminals of the thyristor assembly 7 are connected to the power supply line, and the output terminals thereof connected to the load line. The gate of the thyristor assembly 7 receives the control signal issued by the control device and amplified by a photoelectric-isolating and driving circuit.

The thyristor assembly 7 of the contactless intelligent switchgear according to the invention may be provided with a cooling system, which may be a water-cooling system or a wind-cooling system. The water-cooling system is generally a water cycling system, the water jacket of the water cycling system being arranged on the thyristor assembly. The wind-cooling system may be a fan arranged on the housing and focused on the radiators of the thyristor assembly. A startup control circuit of the cooling system is connected with an relevant interface of the control device. A startup control signal is issued by the control device in response to a real-time judgment based on the temperature sampling results.

The following is a more detailed descriptions of the control device of the contactless intelligent switchgear according to the invention.

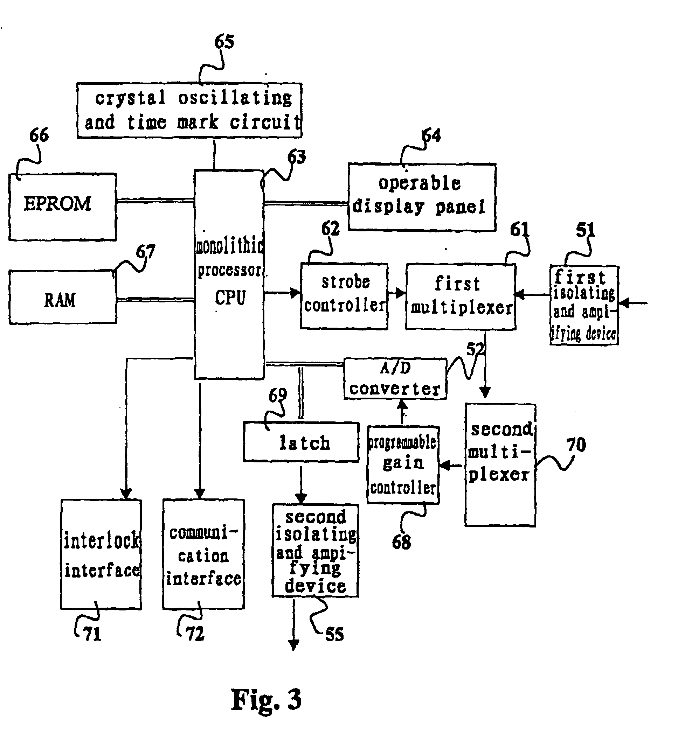

As shown in figure 3, the control device of the contactless intelligent switchgear according to the invention comprises a first isolating and amplifying device 51, a first multiplexer 61, a strobe controller 62, a programmable gain controller 68, an A/D converter 52, a monolithic processor CPU 63, a crystal oscillating and time mark circuit 65, EPROM 66, RAM 67, a latch 69, a second multiplexer 70, an operable display panel 64, a second isolating and amplifying device 55, an interlock interface 71, a communication interface 72 and relevant control circuit etc.. In the control device 5, the analog signals from the signal sampler 3 is filtered through the first isolating and amplifying device 51 to remove the clutters therein. The control device 5 implements signal strobe by a combination of the first multiplexer 61 and the monolithic processor CPU 63, and then sends the signals to the monolithic processor CPU 63 by the programmable gain controller 68. The monolithic processor CPU 63 implements various control functions and issues digital control signals. The digital control signals, after through the latch 69 and the second isolating and amplifying device 55, are used to control the on/off operation of the thyristor assembly and the operation of the cooling system. The monolithic processor CPU 63, the program memory EPROM 66, the data memory RAM 67, the crystal oscillating and time mark circuit 65 as well as relevant periphery circuit etc. constitute the monolithic processor 53.

The main function of the monolithic processor 53 is to make a short-circuit judgment, an overload delay judgment, a leakage judgment and a temperature protection judgment etc. based on the current sampling signals, to output control signals to control the on/off operation of the thyristor assembly 7 and the operation of the cooling system; to calculate electric energy based on the current sampling signals and the voltage sampling signals; to make interlock control of a plurality of switches based on interlock communication signals; to actuate switches or buttons based on the state of the operable display panel 64 to select various functions; and to implement a remote control via a real-time communication with an external computer.

The monolithic processor 53 can make a temperature protection judgment based on the sampling results of the temperature sampler, and output control signals as required to the cooling system and the thyristor assembly 7. Suppose that a nominal temperature value is T1, a maximum temperature value T2, and a control temperature threshold ΔT, then the condition to prevent the cooling system from being frequently actuated is that the cooling system is actuated when the temperature of the thyristor assembly 7 is higher than T1 + ΔT, and is deactuated when the temperature of the thyristor assembly 7 is lower than T1-ΔT. When the temperature of the thyristor assembly 7 is higher than the maximum temperature T2, the monolithic processor issues an off signal to turn off the thyristor assembly 7.

The monolithic processor 53 also exchanges interlock signals with other contactless intelligent switchgears via the interlock interface 71 to judge the on/off state of other contactless intelligent switchgears so as to be automatically put into operation when other contactless intelligent switchgear is in voltage-losing state. In particular, when a contactless intelligent switchgear functions as an interconnection switch by setting the operable display panel 64, a continuous judgment on the sampled interlock signals is performed. If other contactless intelligent switchgears are in voltage-losing and off state, the present contactless intelligent switchgear functioning as an interconnection switch is set to be in a closed state. If other contactless intelligent switchgears send a closing request signal to the present contactless intelligent switchgear it is set to be in an opened state.

The monolithic processor 53 can measure the electric energy in the following ways: making numerical integration and effective value setting based on the sampling results of the voltage signals and the current signals, converting the sampling results into effective values of the voltages and the currents, calculating an electric power by multiplying the voltages by the currents, and integrating the electric power to obtain the electric energy.

The monolithic processor 53 can make a short-circuit judgment. A short-circuit current value is set to be several times of the nominal current. The monolithic processor 53 compares the sampled current value with the short-circuit current value. If the sampled current value is higher than the short-circuit current value, it is judged that a short-circuit fault occurs. In this case, the thyristor assembly 7 is controlled to be in an opened state.

The monolithic processor 53 can make an overload delay judgment. If the sampled current value is larger than the nominal current, but is less than the short-circuit current value, it is judged that an overload occurs. The open delay time can be determined based on an overload ratio. The more the overload ratio is, the shorter the delay time is, and vice versa so as to conform the inverse timelimit characteristic as required by overcurrent when actuating in a state of overload. When the overload time is larger than the delay time, a signal for turning off the thyristor assembly is issued.

The monolithic processor 53 can also make a leakage judgment. When the sampled value of a leakage current is larger than a setting value, it is judged that a leakage occurs, and a signal to turn off the thyristor assembly is timely issued.

The operable display panel of the contactless intelligent switchgear according to the invention is arranged on the front face of the housing thereof. The operable display panel is provided with on/off operation keys, function setting keys, parameter setting keys and display panel. The on/off operation keys can be used to manually turn on/off the contactless intelligent switchgear. The function setting keys can be used to set the contactless intelligent switchgear to function as a single switch or an interlock switch. When functioning as a single switch, the contactless intelligent switchgear can also be set as a timing switch or a non-timing switch. The non-timing switch can be set to be in a holding state or a non-holding state, i.e., it may be a shunt-field trip/voltage-loss trip switch. When functioning as an interlock switch, the contactless intelligent switchgear can be set as a main switch or an interconnection switch in the interlock state, and meanwhile, can also be set as in an automatic state or a manual state. The parameter setting keys can be used to set all the parameters for fulfilling various protection functions. The display panel is provided with indication lamps indicating the on/off states of the switchgear, and infrared numerical tubes or display for selectively indicating currents, voltages, electric energy, times as well as parameter setting values.

The interlock interface 71 of the contactless intelligent switchgear according to the invention is an interface for exchanging interlock information between the monolithic processor incorporated in the control device thereof and other contactless intelligent swichgears, wherein the communication interface is used to exchange information with a computer.

The various protection judgments, the interlock control and data exchanges with the computer are mainly fulfilled by a software in the monolithic processor. The software is solidified in the EPROM, and the sampling results and calculating results within a predetermined time are restored in a RAM chip by the monolithic processor. The current effective values, the voltage effective values and the measuring results of electric energy processed by the software in the monolithic processor are output to the display panel to be displayed thereon. The on/off state of the switches is indicated on the indicating lamps arranged on the panel. The control signal for the thyristor assembly and the control signal for the cooling system, after being isolated and amplified, are used to control the on/off operation of the thyristor assembly and the operation of the cooling system. The monolithic processor in the control device receives and processes the control signal and function selecting signal from the operable display panel, wherein the function selecting keys on the operable display panel, together with the monolithic processor, can fulfill selections of various control functions. The parameter setting keys on the operable display panel can set the nominal current, the short-circuit current, the overload delay, and the timings etc. of the switch. The operating keys and display switching keys can fulfill the switching display of currents, voltages, electric energy and timings etc.. The communication interface can fulfill the real-time communication, data exchanges and remote control with an universal computer. The computer can input parameters and control instructions to the monolithic processor via the input/output interface, and meanwhile can read parameters from the memory of the monolithic processor so as to fulfill a remote control.

### Industrial Applicability

As compared with a conventional switchgear, the contactless intelligent switchgear according to the invention has the following advantages: 1. In the contactless intelligent switchgear according to the invention, since the thyristor assembly is substituted for mechanical contact devices, it has no mechanical wearing, and thus has a remarkable increased service life. Further, no arc occurs during switching on/off operation, so that the loss due to melting and cauterant of the contacts of the switchgear can be avoided, and the switchgear can reliably switch on/off. 2. Since the contactless intelligent switchgear according to the invention can fulfill a plurality of protection functions without needing relays, voltage transformers and current transformers etc., and without needing electric energy meter, the measuring and control system of the switchgear is greatly simplified, and the reliability of the switchgear is remarkably improved.

## Claims

1. A contactless intelligent switchgear, comprising:
a thyristor assembly (7), having an input terminal connected to the power supply line and having an output terminal, serving as an output terminal of the contactless intelligent switchgear, connected to a load line,
a signal sampler (3), having an input terminal connected to a power supply line, for sampling an electric signal from the power supply line;
a control device (5), receiving at its input terminal the sampling signal from the signal sampler (3), and outputting a control signal based on predetermined control conditions to control the on/off operation of said thyristor assembly (7),
**characterised by**
said switchgear also comprising a power source device (1) connected with said signal sampler (3), said thyristor assembly (7) and said control device (5) respectively to feed an electric power to said signal sampler (3), said thyristor assembly (7) and said control device (5);
said thyristor assembly (7) further comprising a cooling system;
said signal sampler (3) also sampling:
the temperature signal of said thyristor assembly (7); and
the leakage current of the load line;
said control device (5), receiving at its input terminal also the sampling signals for the leakage current and the temperature from the signal sampler (3), and outputting control signals based on predetermined control conditions to control also the operation of said cooling system and to fulfill a leakage protection;
the control device (5) further comprising:
a first isolating and amplifying device (51) for isolating and amplifying the sampling signals from said signal sampler (3);
an A/D converter (52) for A/D converting the sampling signals from said first isolating and amplifying device (51), and outputting sampling data;
a monolithic processor (53) for receiving the sampling data from said A/D converter (52), making mathematical operations and logical judgements by a preset program, and outputting digital control signal based on operation demands;
a D/A converter (54) for converting the digital control signals from said monolithic processor (53) into analog control signals; and
a second isolating and amplifying device (55) for isolating and amplifying the analog control signals from said D/A converter (54) to control said thyristor assembly (7).

2. The contactless intelligent switchgear as claimed in claim 1, **characterised in that** said control device (5) is connected with a computer to fulfill a real-time detection and a remote control.

3. The contactless intelligent switchgear as claimed in claim 1 or 2, **characterised in that** said signal sampler (3) comprises a current sampler directly connected in series between said thyristor assembly (7) and the power supply line for sampling currents.

4. The contactless intelligent switchgear as claimed in claim 1, 2 or 3, **characterised in that** said control device (5) is connected with the control devices of other contactless intelligent switchgears to exchange interlock signals, and to make judgements so as to fulfill an uninterrupted power supply.

## Patentansprüche

1. Kontaktlose intelligente Schalteinrichtung, mit:
einer Thyristor-Baugruppe (7) mit einem mit der Energieversorgungsleitung verbundenen Eingangsanschluss und mit einem als Ausgangsanschluss der kontaktlosen intelligenten Schaltungseinrichtung dienenden, mit einer Lastleitung verbundenen Ausgangsanschluss,
einem Signalabtaster (3) mit einem an eine Energieversorgungsleitung angeschlossenen Eingangsanschluss zum Abtasten eines elektrischen Signals von der Energieversorgungsleitung;
einem Steuergerät (5) das an seinem Eingangsanschluss das Abtastsignal vom Signalabtaster (3) empfängt, und das ein auf vorbestimmten Steuerbedingungen basierendes Steuersignal zum Steuern der Ein-/Ausfunktion der Thyristor-Baugruppe (7) ausgibt,
**dadurch gekennzeichnet, dass**
die Schalteinrichtung zusätzlich ein mit dem Signalabtaster (3), der Thyristor-Baugruppe (7) und dem Steuergerät (5) jeweils verbundenes Stromquellengerät (1) aufweist zum Anlegen elektrische Energie an den Signalabtaster (3), die Thyristor-Baugruppe (7) und das Steuergerät (5); die Thyristor-Baugruppe (7) weiter ein Kühlsystem aufweist;
der Signalabtaster (3) außerdem das Temperatursignal der Thyristor-Baugruppe (7) und den Verluststrom der Lastleitung abtastet;
das Steuergerät (5) an seinem Eingangsanschluss auch das Abtastsignal für den Leckstrom und die Temperatur vom Signalabtaster (3) empfängt und Steuersignale basierend auf vorbestimmten Steuerbedingungen zur Steuerung der Funktion des Kühlsystems und zur Erreichung eines Leckstromschutzes ausgibt;
das Steuergerät (5) weiter ein erstes Isolier- und Verstärkungsgerät (51) zur Isolierung und Verstärkung des Abtastsignals vom Signalabtaster (3) aufweist;
ein A/D-Umwandler (52) zum A/D Wandeln des Abtastsignals vom ersten Isolier- und Verstärkungsgerät (51) und zum Ausgeben von Abtastdaten vorgesehen ist;
ein Monolit-Prozessor (53) zum Empfangen der Abtastdaten vom A/D-Wandler (52),zum Durchführen mathematischer Operationen und logischer Entscheidungen durch ein vorgegebenes Programm und zum Ausgeben digitaler Steuersignale basierend auf Funktionsanforderungen vorgesehen ist;
ein D/A-Wandler (54) zum Wandeln der digitalen Steuersignale vom Monolit-Prozessor (53) in analoge Kontrollsignale vorgesehen ist; und
ein zweites Isolier- und Verstärkungsgerät (55) zum Isolieren und Verstärken der analogen Steuersignale vom D/A-Wandler (54) zum Steuern der Thyristor-Baugruppe (7) vorgesehen ist.

2. Kontaktlose intelligente Schalteinrichtung nach Anspruch 1, **dadurch gekennzeichnet, dass** das Steuergerät (5) mit einem Computer zum Erreichen einer Echtzeit Erkennung und einer Fernsteuerung verbunden ist.

3. Kontaktlose intelligente Schalteinrichtung nach Anspruch 1 oder 2, **dadurch gekennzeichnet, dass** der Signalabtaster (3) zum Abtasten von Strom einen direkt in Reihe zwischen der Thyristor-Baugruppe (7) und der Energieversorgungsleitung geschalteten Stromabtaster aufweist.

4. Kontaktlose intelligente Schalteinrichtung nach einem der Ansprüche 1, 2 oder 3, **dadurch gekennzeichnet, dass** das Steuergerät (5) mit den Steuergeräten anderer kontaktloser intelligenter Schalteinrichtungen zum Austausch von Verriegelungssignalen und um Entscheidungen zum Erreichen einer ununterbrochenen Stromversorgung zu treffen verbunden ist.

## Revendications

1. Mécanisme de commutation intelligent sans contact, comprenant :
-- un montage à thyristors (7), comportant une borne d'entrée connectée à une ligne d'alimentation électrique et une borne de sortie, servant de borne de sortie pour le mécanisme de commutation intelligent sans contact, connectée à une ligne de charge,
-- un échantillonneur de signal (3), comportant une borne d'entrée connectée à une ligne d'alimentation électrique, pour échantillonner un signal électrique provenant de la ligne d'alimentation électrique,
-- un dispositif de commande (5), recevant à sa borne d'entrée le signal d'échantillonnage provenant de l'échantillonneur de signal (3), et produisant à sa sortie un signal de commande basé sur des conditions de commande prédéterminées pour commander le fonctionnement d'ouverture ou de fermeture du montage à thyristors (7),
**caractérisé en ce que**
-- ledit mécanisme de commutation comporte aussi un dispositif d'alimentation électrique (1) connecté à l'échantillonneur de signal (3), au montage à thyristors (7) et au dispositif de commande (5) respectivement pour fournir de la puissance électrique audit échantillonneur de signal (3), au montage à thyristors (7) et au dispositif de commande (5) ;
-- le dit montage à thyristors (7) comprenant de plus un système de refroidissement ;
-- le dit échantillonneur de signal (3) échantillonnant aussi :
le signal de température du dit montage à thyristors (7) ; et
le courant de fuite de la ligne de charge ;
-- le dit dispositif de commande (5), recevant à sa borne d'entrée aussi les signaux d'échantillonnage représentatifs du courant de fuite et de la température issus de l'échantillonneur de signal (3), et produisant à sa sortie des signaux de commande sur la base des conditions de commande prédéterminées pour commander aussi le fonctionnement du dit système de refroidissement et pour assurer une protection contre les fuites ;
le dispositif de commande (5) comprenant de plus :
-- un premier dispositif d'isolation et d'amplification (51) pour isoler et amplifier les signaux échantillonnés provenant du dit échantillonneur de signal (3) ;
-- un convertisseur analogique numérique (52) pour réaliser la conversion analogique numérique des signaux d'échantillonnage provenant du dit dispositif d'isolation et d'amplification (51), et pour fournir en sortie des données d'échantillonnage ;
-- un processeur monolithique (53) pour recevoir les données d'échantillonnage provenant du dit convertisseur analogique numérique (52), exécutant des opérations mathématiques et des tests logiques selon un programme préétabli, et produisant en sortie un signal de commande numérique sur la base d'une demande de fonctionnement ;
-- un convertisseur numérique analogique (54) pour convertir les signaux de commande numérique provenant du dit processeur monolithique (53) en signaux de commande analogique ; et
-- un second dispositif d'isolation et d'amplification (55) pour isoler et amplifier les signaux de commande analogique provenant du dit convertisseur numérique analogique (54) pour commander le dit montage à thyristors (7).

2. Mécanisme de commutation intelligent sans contact selon la revendication 1, **caractérisé en ce que** le dit dispositif de commande (5) est connecté avec un ordinateur pour assurer une détection en temps réel et une télécommande.

3. Mécanisme de commutation intelligent sans contact selon l'une quelconque des revendications 1 ou 2, **caractérisé en ce que** le dit échantillonneur de signal (3) comporte un échantillonneur en courant connecté directement en série entre le dit montage à thyristors (7) et la ligne d'alimentation électrique pour échantillonner les courants.

4. Mécanisme de commutation intelligente sans contact selon l'une quelconque des revendications 1, 2 ou 3, **caractérisé en ce que** le dit dispositif de commande (5) est connecté aux dispositifs de commande d'autres mécanismes de commutation intelligents sans contact pour échanger des signaux de verrouillage mutuel et pour exécuter des tests de façon à assurer une alimentation électrique sans interruption.
